# EUROPEAN PATENT SPECIFICATION

(11) **EP 4 220 612 B1**
(45) Date of publication and mention of the grant of the patent: **04.06.2025**
(21) Application number: 23151056.1
(22) Date of filing: 11.01.2023
(51) Int. Cl.: G09F 9/302, G09F 9/33, H01R 13/629, H01R 31/06, H01R 13/639

(54) **PLUG-IN CONNECTION ASSEMBLY OF LED DISPLAY DEVICE, LED BOX ASSEMBLY AND LED DISPLAY DEVICE**
STECKVERBINDUNGSANORDNUNG EINER LED-ANZEIGEVORRICHTUNG, LED-BOXANORDNUNG UND LED-ANZEIGEVORRICHTUNG
ENSEMBLE DE CONNEXION ENFICHABLE DE DISPOSITIF D'AFFICHAGE À DEL, ENSEMBLE BOÎTIER À DEL ET DISPOSITIF D'AFFICHAGE À DEL

(30) Priority: 28.01.2022 CN 202210109427
(43) Date of publication of application: 02.08.2023
(73) Proprietor: Leyard Optoelectronic Co., Ltd, Beijing 100091 (CN)
(72) Inventor: CAO, Linhua, Beijing, 100091 (CN); LIU, Zhiyong, Beijing, 100091 (CN)
(74) Representative: Berggren Oy

(56) References cited:
- WO-A1-2015/036330
- CN-A- 113 036 520
- US-A1- 2017 093 106
- US-A1- 2020 102 977

## Description

### Technical Field

The invention relates to a technical field of light-emitting diode (LED) display, and particularly to a plug-in connection assembly of an LED display device, an LED box assembly and an LED display device.

### Background

A large-sized light-emitting diode (LED) display device is formed by splicing several smaller LED boxes, and it is required to connect power wires and data wires to each other to splice the smaller LED boxes into a larger whole. Generally, power wires and data wires are connected for splicing. However, since the wires are distributed at the backs of the spliced LED boxes and complicatedly connected, the device looks untidy. In addition, non-staff can cut off the connection, such that the problem of insecurity is likely to occur.

Prior art document WO 2015/036330 A1 discloses a plug-in connection assembly for an LED display device with first and second plug-in connection members and an intermediate structure comprising third and fourth plug-in connection members that connect to the first and second members respectively in a connected state. It lacks a driving member for actively moving these intermediate plug-in members, relying on a more passive connection mechanism.

### Summary

The main objective of the invention is to provide a plug-in connection assembly of a light-emitting diode (LED) display device, an LED box assembly and an LED display device, so as to solve the problem of insecurity caused because wires are distributed at backs of LED boxes.

The invention is as defined in claim 1.

In order to realize the above objective, an aspect of the invention provides a plug-in connection assembly of an LED display device. The plug-in connection assembly of an LED display device includes a first plug-in connection member; a second plug-in connection member spaced apart from the first plug-in connection member; and an intermediate structure arranged between the first plug-in connection member and the second plug-in connection member. The intermediate structure includes a third plug-in connection member and a fourth plug-in connection member that are spaced apart from each other, and a driving member for driving the third plug-in connection member and the fourth plug-in connection member to move, and the third plug-in connection member and the fourth plug-in connection member are connected with each other by a wire. The driving member has an initial position and a pushing position. When the driving member is in the initial position, the third plug-in connection member and the fourth plug-in connection member are close to each other, the third plug-in connection member is separated from the first plug-in connection member, and the fourth plug-in connection member is separated from the second plug-in connection member. When the driving member is in the pushing position, the third plug-in connection member and the fourth plug-in connection member are away from each other, the third plug-in connection member is connected with the first plug-in connection member in a plug-in manner, and the fourth plug-in connection member is connected with the second plug-in connection member in a plug-in manner.

Further, the intermediate structure further includes a separator for separating the third plug-in connection member from the fourth plug-in connection member, and the driving member is rotatably arranged at the separator.

Further, the separator includes a separation frame arranged between the third plug-in connection member and the fourth plug-in connection member and a connection plate arranged at the separation frame, and the driving member is rotatably arranged at the connection plate.

Further, the driving member includes a rotary shaft, a driving block arranged at a first end of the rotary shaft, and an operation portion arranged at a second end of the rotary shaft. An axis of the rotary shaft is perpendicular to a moving direction of the third plug-in connection member or the fourth plug-in connection member, the rotary shaft rotatably penetrates the connection plate, and the driving block may push the third plug-in connection member and the fourth plug-in connection member, so as to drive the third plug-in connection member and the fourth plug-in connection member to be away from each other.

Further, the intermediate structure further includes a rotary sleeve sleeving the rotary shaft and fixed to the rotary shaft, the rotary sleeve includes a sleeve body located between the connection plate and the rotary shaft, and a stop plate arranged at an end of the sleeve body away from the operation portion, and the stop plate and the operation portion are located on two sides of the connection plate respectively.

Further, the intermediate structure further includes an elastic member connected between the third plug-in connection member and the fourth plug-in connection member, and the elastic member exerts an elastic force on the third plug-in connection member and the fourth plug-in connection member, so as to move the third plug-in connection member and the fourth plug-in connection member from positions away from each other to positions close to each other.

Further, the intermediate structure further includes a locking member movably arranged on the driving member, a first locking portion and a second locking portion that are spaced apart from each other are arranged on the separator, when the driving member is in the pushing position, the locking member may match the first locking portion in a locking manner, and when the driving member is in the initial position, the locking member may match the second locking portion in a locking manner.

Further, the intermediate structure further includes a fixing plate and two limiting folded plates arranged at two ends of the fixing plate, a part of the separator is fixed at a middle position of the fixing plate, and the third plug-in connection member and the fourth plug-in connection member are located between the two limiting folded plates.

Further, a first positioning structure is arranged between the third plug-in connection member and the first plug-in connection member, and a second positioning structure is arranged between the fourth plug-in connection member and the second plug-in connection member.

Another aspect of the invention provides an LED box assembly. The LED box assembly includes a first box, a second box and a plug-in connection assembly. The plug-in connection assembly is the above plug-in connection assembly of an LED display device, the first box and the second box are arranged adjacent to each other, the first box includes a first side plate, the second box includes a second side plate adjacent to the first side plate, a first plug-in connection member of the plug-in connection assembly is arranged at the first side plate, and a second plug-in connection member of the plug-in connection assembly is arranged at the second side plate.

Another aspect of the invention provides an LED display device. The LED display device includes an LED box assembly and an LED display screen arranged on a front side of the LED box assembly, and the LED box assembly is the above LED box assembly.

By applying the technical solution of the invention, a plug-in connection assembly of an LED display device includes a first plug-in connection member, a second plug-in connection member and an intermediate structure. The first plug-in connection member and the second plug-in connection member may be mounted on two adjacent LED boxes respectively, such that the second plug-in connection member is spaced apart from the first plug-in connection member. The intermediate structure is arranged between the first plug-in connection member and the second plug-in connection member, and the intermediate structure includes a third plug-in connection member and a fourth plug-in connection member that are spaced apart from each other, and a driving member for driving the third plug-in connection member and the fourth plug-in connection member to move, and the third plug-in connection member and the fourth plug-in connection member are connected with each other by a wire. In the invention, the driving member has an initial position and a pushing position. When the driving member is in the initial position, the third plug-in connection member and the fourth plug-in connection member are close to each other, the third plug-in connection member is separated from the first plug-in connection member, and the fourth plug-in connection member is separated from the second plug-in connection member. When the driving member is in the pushing position, the third plug-in connection member and the fourth plug-in connection member are away from each other, the third plug-in connection member is connected with the first plug-in connection member in a plug-in manner, and the fourth plug-in connection member is connected with the second plug-in connection member in a plug-in manner. The first plug-in connection member, the second plug-in connection member and the intermediate structure may integrate power wires and data wires together to realize connection and disconnection. In this way, the movable third plug-in connection member and fourth plug-in connection member are arranged between LED boxes, the third plug-in connection member is connected with the first plug-in connection member in a plug-in manner, and the fourth plug-in connection member is connected with the second plug-in connection member in a plug-in manner, so as to realize communication. The intermediate structure is connected with, in a plug-in manner, and separated from the first plug-in connection member and the second plug-in connection member to replace adjacent power wires and data wires, such that connection is simple, and backs of the LED boxes may be tidy after the LED boxes are spliced. Moreover, staff may easily cut off the connection, so as to improve security of operation. Therefore, the technical solution of the invention may solve the problem of insecurity caused because wires are distributed at backs of LED boxes.

### Brief Description of the Drawings

The accompanying drawings of the description, which constitute part of the invention, are used to provide further understanding of the invention, and illustrative examples of the invention and the description thereof are used to explain the invention, but are not intended to unduly limit the invention. In the accompanying drawings:
Fig. 1 shows a solid schematic structural diagram of an example of a plug-in connection assembly of a light-emitting diode (LED) display device according to the invention;
Fig. 2 shows an exploded schematic structural diagram of the plug-in connection assembly of an LED display device in Fig. 1;
Fig. 3 shows a partial solid schematic structural diagram of an intermediate structure of the plug-in connection assembly of an LED display device in Fig. 1;
Fig. 4 shows a solid schematic structural diagram of a third plug-in connection member and a fourth plug-in connection member of the plug-in connection assembly of an LED display device in Fig. 1;
Fig. 5 shows a solid schematic structural diagram of a separator of the plug-in connection assembly of an LED display device in Fig. 1;
Fig. 6 shows a schematic front view of a driving member of the plug-in connection assembly of an LED display device in Fig. 1 located on a connection plate;
Fig. 7 shows an exploded schematic structural diagram of a driving member of the plug-in connection assembly of an LED display device in Fig. 1;
Fig. 8 shows a partial solid schematic structural diagram of a connection plate of the plug-in connection assembly of an LED display device in Fig. 1;
Fig. 9 shows a schematic front view of the plug-in connection assembly of an LED display device in Fig. 1;
Fig. 10 shows a schematic left view of the plug-in connection assembly of an LED display device in Fig. 9;
Fig. 11 shows a schematic top view of the plug-in connection assembly of an LED display device in Fig. 9;
Fig. 12 shows a schematic sectional view of the plug-in connection assembly of an LED display device in Fig. 1 in a length direction thereof;
Fig. 13 shows a schematic sectional view of the plug-in connection assembly of an LED display device in Fig. 1 in a width direction thereof;
Fig. 14 shows a schematic rear view of an example of an LED box assembly according to the invention; and
Fig. 15 shows a schematic side view of the LED box assembly in Fig. 14.

The above accompanying drawings include the following reference numerals:
10: first plug-in connection member; 20: second plug-in connection member; 30: intermediate structure; 31: third plug-in connection member; 32: fourth plug-in connection member; 33: driving member; 331, rotary shaft; 332, driving block; 333, operation portion; 34, wire; 35: separator; 351: separation frame; 352, connection plate; 353, first locking portion; 354, second locking portion; 36, rotary sleeve; 361, sleeve body; 362, stop plate; 37: elastic member; 38: locking member; 391, fixing plate; 392, limiting folded plate; 41: first box; and 42: second box.

### Detailed Description of the Embodiments

The technical solutions of the examples of the invention will be clearly and completely described below in combination with the accompanying drawings in the examples of the invention. Apparently, the described examples are merely some examples rather than all examples of the invention.

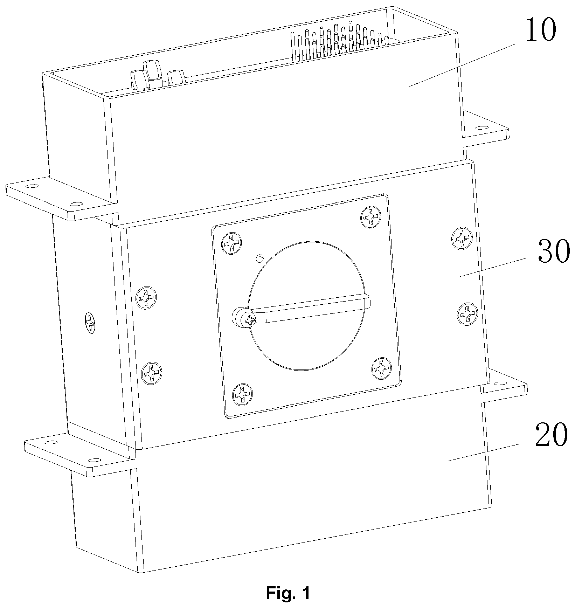

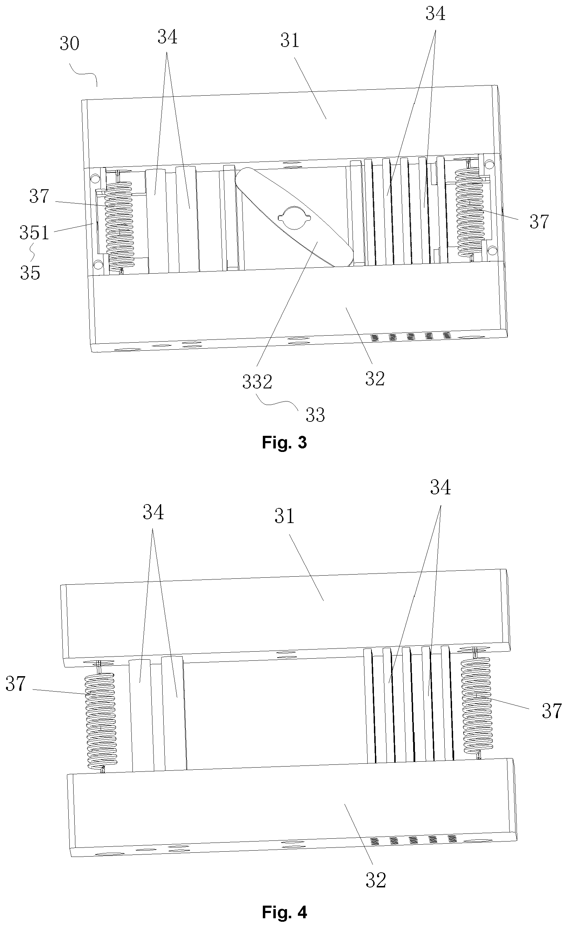

As shown in Figs. 1-3 and 14, a plug-in connection assembly of a light-emitting diode (LED) display device in the embodiment includes: a first plug-in connection member 10, a second plug-in connection member 20 and an intermediate structure 30. The second plug-in connection member 20 is spaced apart from the first plug-in connection member 10. The intermediate structure 30 is arranged between the first plug-in connection member 10 and the second plug-in connection member 20, and the intermediate structure 30 includes a third plug-in connection member 31 and a fourth plug-in connection member 32 that are spaced apart from each other, and a driving member 33 for driving the third plug-in connection member 31 and the fourth plug-in connection member 32 to move, and the third plug-in connection member 31 and the fourth plug-in connection member 32 are connected with each other by a wire 34. In the embodiment, the driving member 33 has an initial position and a pushing position. When the driving member 33 is in the initial position, the third plug-in connection member 31 and the fourth plug-in connection member 32 are close to each other, the third plug-in connection member 31 is separated from the first plug-in connection member 10, and the fourth plug-in connection member 32 is separated from the second plug-in connection member 20. When the driving member 33 is in the pushing position, the third plug-in connection member 31 and the fourth plug-in connection member 32 are away from each other, the third plug-in connection member 31 is connected with the first plug-in connection member 10 in a plug-in manner, and the fourth plug-in connection member 32 is connected with the second plug-in connection member 20 in a plug-in manner.

By applying the technical solution of the example, the first plug-in connection member 10 and the second plug-in connection member 20 may be mounted on two adjacent LED boxes respectively, such that the second plug-in connection member 20 is spaced apart from the first plug-in connection member 10. The intermediate structure 30 is arranged between the first plug-in connection member 10 and the second plug-in connection member 20, and the intermediate structure 30 includes a third plug-in connection member 31 and a fourth plug-in connection member 32 that are spaced apart from each other, and a driving member 33 for driving the third plug-in connection member 31 and the fourth plug-in connection member 32 to move, and the third plug-in connection member 31 and the fourth plug-in connection member 32 are connected with each other by a wire 34. In the embodiment, the driving member 33 has an initial position and a pushing position. When the driving member 33 is in the initial position, the third plug-in connection member 31 and the fourth plug-in connection member 32 are close to each other, the third plug-in connection member 31 is separated from the first plug-in connection member 10, and the fourth plug-in connection member 32 is separated from the second plug-in connection member 20. When the driving member 33 is in the pushing position, the third plug-in connection member 31 and the fourth plug-in connection member 32 are away from each other, the third plug-in connection member 31 is connected with the first plug-in connection member 10 in a plug-in manner, and the fourth plug-in connection member 32 is connected with the second plug-in connection member 20 in a plug-in manner. The first plug-in connection member 10, the second plug-in connection member 20 and the intermediate structure 30 may integrate power wires and data wires together to realize connection and disconnection. In this way, the movable third plug-in connection member 31 and fourth plug-in connection member 32 are arranged between LED boxes, the third plug-in connection member 31 is connected with the first plug-in connection member 10 in a plug-in manner, and the fourth plug-in connection member 32 is connected with the second plug-in connection member 20 in a plug-in manner, so as to realize communication. The intermediate structure 30 is connected with, in a plug-in manner, and separated from the first plug-in connection member 10 and the second plug-in connection member 20 to replace adjacent power wires and data wires, such that connection is simple, and backs of the LED boxes may be tidy after the LED boxes are spliced. Moreover, staff may easily cut off the connection, so as to improve security of operation. Therefore, the technical solution of the example may solve the problem of insecurity caused because wires are distributed at backs of LED boxes. In addition, the first plug-in connection member 10, the second plug-in connection member 20 and the intermediate structure 30 may replace wire connection between boxes in the related art, such that after the whole LED display device is assembled, a rapid connection function between power sources and signals is realized, junctions between the boxes are controlled to be connected or disconnected, assembly or disassembly between the boxes by field personnel is facilitated, and the problem of difficulty in introducing external power sources and signals is solved.

It should be noted that in the situation that the third plug-in connection member 31 and the fourth plug-in connection member 32 are close to each other, and the third plug-in connection member 31 and the fourth plug-in connection member 32 are away from each other, "close to each other" is relative to "away from each other", that is, a distance between the third plug-in connection member 31 and the fourth plug-in connection member 32 when the third plug-in connection member 31 and the fourth plug-in connection member 32 are close to each other is less than a distance between the third plug-in connection member 31 and the fourth plug-in connection member 32 when the third plug-in connection member 31 and the fourth plug-in connection member 32 are away from each other. In order to prevent the wire 34 from being torn when the third plug-in connection member 31 and the fourth plug-in connection member 32 are close to or away from each other, the wires 34 in the embodiment are relatively loose or elastic.

The above driving member drives the third plug-in connection member 31 and the fourth plug-in connection member 32 to linearly move.

Specifically, the first plug-in connection member 10 and the second plug-in connection member 20 are provided with plastic parts, power copper pins, signal copper pins, power welding wire positions, and signal printed circuit board (PCB) welding positions.

The third plug-in connection member 31 and the fourth plug-in connection member 32 are provided with power copper pins, signal copper pins, guide columns, power welding wire positions and signal PCB welding positions. The power copper pins are used for being connected with power copper holes of the plug-in connection members in a plug-in manner. The signal copper pins are used for being connected with signal copper holes of the plug-in connection members in a plug-in manner. The power welding wire positions are used for connecting welding wires to an internal power source of the LED display device. The signal PCB welding positions are used for welding a PCB and connecting a plug-in connection terminal welded on the PCB to a signal in the LED display device.

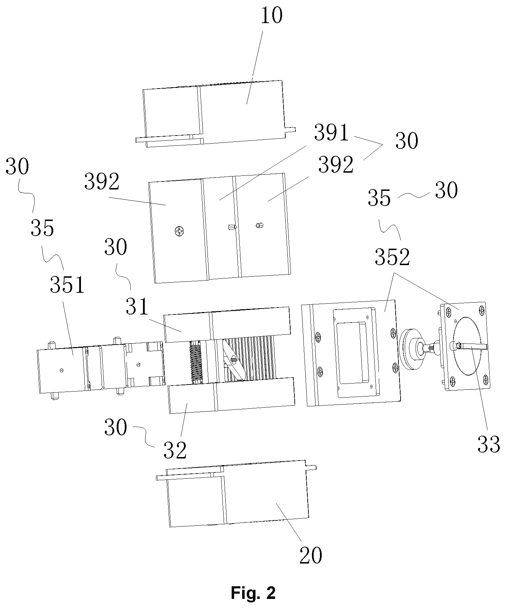

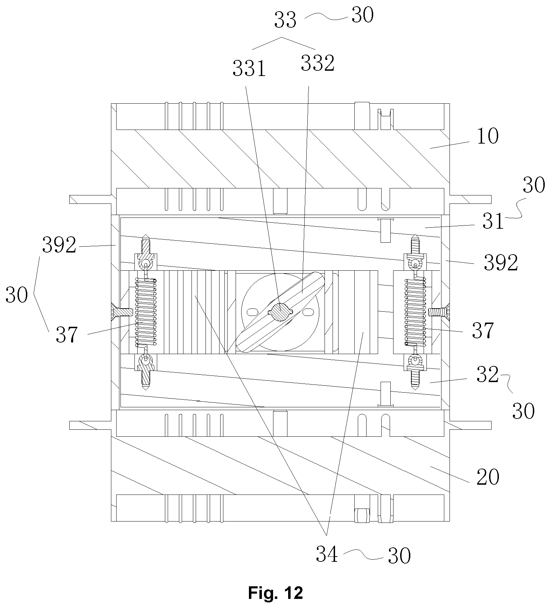

As shown in Figs. 2-5, 12 and 13, the intermediate structure 30 further includes a separator 35 separating the third plug-in connection member 31 from the fourth plug-in connection member 32. The driving member 33 is rotatably arranged at the separator 35. In a process that the third plug-in connection member 31 and the fourth plug-in connection member 32 get close to each other, the separator 35 is arranged to separate the third plug-in connection member 31 and the fourth plug-in connection member 32, so as to prevent collision caused because the third plug-in connection member 31 and the fourth plug-in connection member 32 continuously get close to each other.

As shown in Figs. 2-5, 12 and 13, the separator 35 includes a separation frame 351 arranged between the third plug-in connection member 31 and the fourth plug-in connection member 32, and a connection plate 352 arranged on the separation frame 351. The driving member 33 is rotatably arranged at the connection plate 352. The wire 34 between the third plug-in connection member 31 and the fourth plug-in connection member 32 may pass through a hollowed region of the separation frame 351, and the hollowed region of the separation frame 351 may avoid a part of the driving member 33. In this way, the separation frame 351 does not interfere with a part of the driving member 33 and the wire 34, such that the structure of the intermediate structure 30 is compact. The connection plate 352 is arranged to conveniently support the driving member 33, such that a part of the driving member 33 may smoothly stretch into the hollowed region of the separation frame 351.

Specifically, the separation frame 351 includes a bottom separation plate, a first side plate and a second side plate that are arranged on two sides of the bottom separation plate, and a first vertical separation plate and a second vertical separation plate that are arranged between the first side plate and the second side plate, the first vertical separation plate and the second vertical separation plate are connected on a surface of the bottom separation plate at intervals, and the first side plate, the first vertical separation plate, the second vertical separation plate and the second side plate are sequentially located on the same surface of the bottom separation plate. A part of the driving member (driving block 332 hereinafter) is located between the first vertical separation plate and the second vertical separation plate, a part of a wire 34 (signal wire) is located between the first side plate and the first vertical separation plate, and another part of the wire 34 (power wire) is located between the second vertical separation plate and the second side plate. In this way, the wire 34 and the part of the driving member are located in respective independent spaces, so as to prevent interference with the wire 34 when a part of the driving member rotates. The above signal wire is used for transmitting signals, and the above power wire is used for transmitting voltages and currents.

Specifically, in order to enable the part of the driving member to stretch in the position between the first vertical separation plate and the second vertical separation plate, the connection plate 352 includes a square hole plate connected with the first side plate and the second side plate, and a rectangular plate nested within a hole of the square hole plate, and the driving member 33 is rotatably arranged in the rectangular plate.

As shown in Figs. 2-5, 12 and 13, the driving member 33 includes a rotary shaft 331, a driving block 332 arranged at a first end of the rotary shaft 331, and an operation portion 333 arranged at a second end of the rotary shaft 331. An axis of the rotary shaft 331 is perpendicular to a moving direction of the third plug-in connection member 31 or the fourth plug-in connection member 32. The rotary shaft 331 rotatably penetrates the connection plate 352, and the driving block 332 may push the third plug-in connection member 31 and the fourth plug-in connection member 32, so as to drive the third plug-in connection member 31 and the fourth plug-in connection member 32 to be away from each other. The operation portion 333 is screwed to drive the rotary shaft 331 to rotate, and the driving block 332 may rotate together, such that the driving block 332 may implement pushing. For ease of machining and low friction against the third plug-in connection member 31 and the fourth plug-in connection member 32, the driving block 332 is in a flat key shape, and the operation portion 333 is a knob.

As shown in Figs. 2-5, 12 and 13, the intermediate structure 30 further includes a rotary sleeve 36 sleeving the rotary shaft 331 and fixed to the rotary shaft 331. The rotary sleeve 36 includes a sleeve body 361 located between the connection plate 352 and the rotary shaft 331, and a stop plate 362 arranged at an end of the sleeve body 361 away from the operation portion 333. The stop plate 362 and the operation portion 333 are located on two sides of the connection plate 352 respectively. The rotary sleeve 36 separates the connection plate 352 from the rotary shaft 331, to prevent abrasion caused because the rotary shaft 331 is in direct contact with the connection plate 352 during rotation, thereby proloning service life of the rotary shaft 331. The stop plate 362 and the operation portion 333 match the connection plate 352 in a stopping manner to prevent the rotary shaft 331 from moving along an axis thereof, such that the rotary shaft 331 may only rotate.

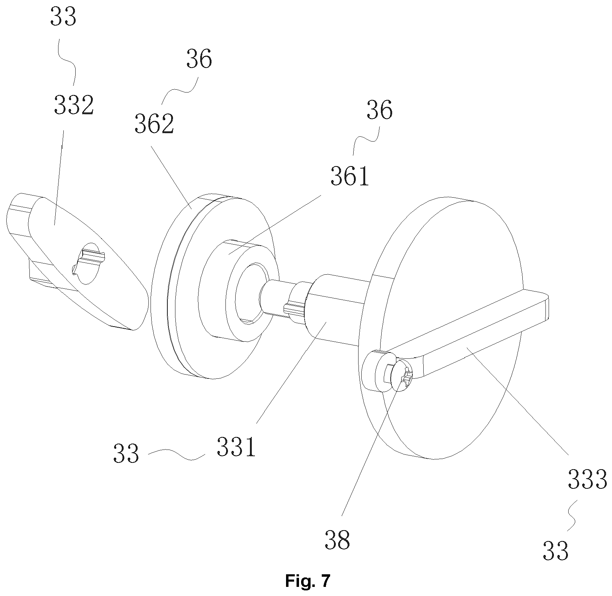

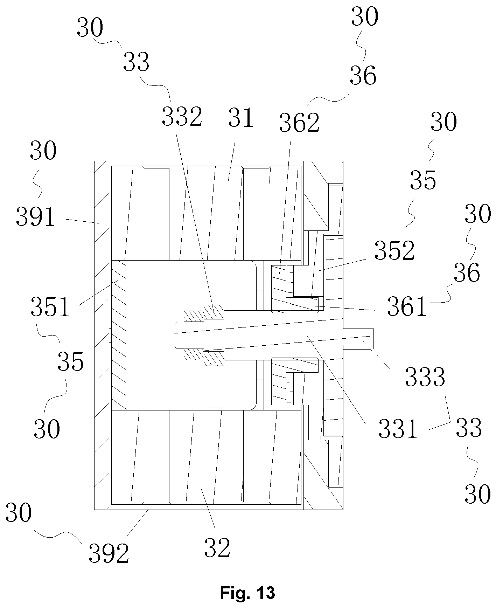

As shown in Figs. 7 and 13, the intermediate structure 30 further includes an anti-wear gasket sleeving the sleeve body 361. In this way, the anti-wear gasket may separate the stop plate 362 from the connection plate 352 to prevent the stop plate 362 from being in direct contact with the connection plate 352, so as to reduce friction occurring during rotation of the rotary sleeve 36. The anti-wear gasket is preferably a plastic part.

As shown in Figs. 2-5, 12 and 13, in a process that the driving member 33 is switched from the pushing position to the initial position, in order to enable the third plug-in connection member 31 and the fourth plug-in connection member 32 to be automatically moved from the positions away from each other to positions close to each other, the intermediate structure 30 further includes an elastic member 37 connected between the third plug-in connection member 31 and the fourth plug-in connection member 32. The elastic member 37 applies an elastic force to the third plug-in connection member 31 and the fourth plug-in connection member 32, so as to move the third plug-in connection member 31 and the fourth plug-in connection member 32 from positions away from each other to positions close to each other. When the third plug-in connection member 31 is in contact with an upper end face of the separation frame 351, and the fourth plug-in connection member 32 is in contact with a lower end face of the separation frame 351, the third plug-in connection member 31 and the fourth plug-in connection member 32 are located at positions close to each other. The elastic member 37 is preferably a tension spring, and the above elastic force is tension.

Specifically, in order to make tension applied by the elastic member to the third plug-in connection member 31 and the fourth plug-in connection member 32 more uniform, two elastic members 37 are arranged, and one elastic member 37 is connected with the third plug-in connection member 31 and the fourth plug-in connection member 32 and located between the first side plate and the first vertical separation plate. The other elastic member 37 is connected with the third plug-in connection member 31 and the fourth plug-in connection member 32 and located between the second vertical separation plate and the second side plate.

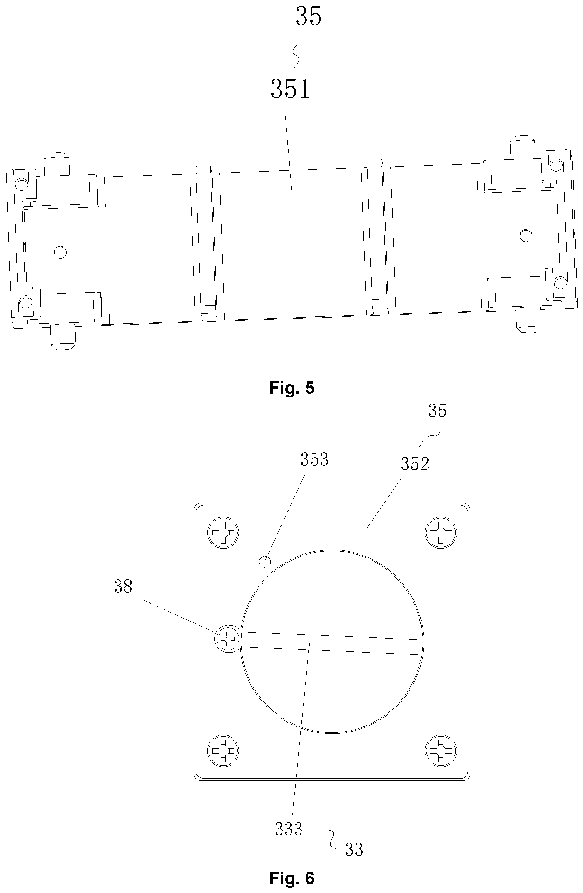

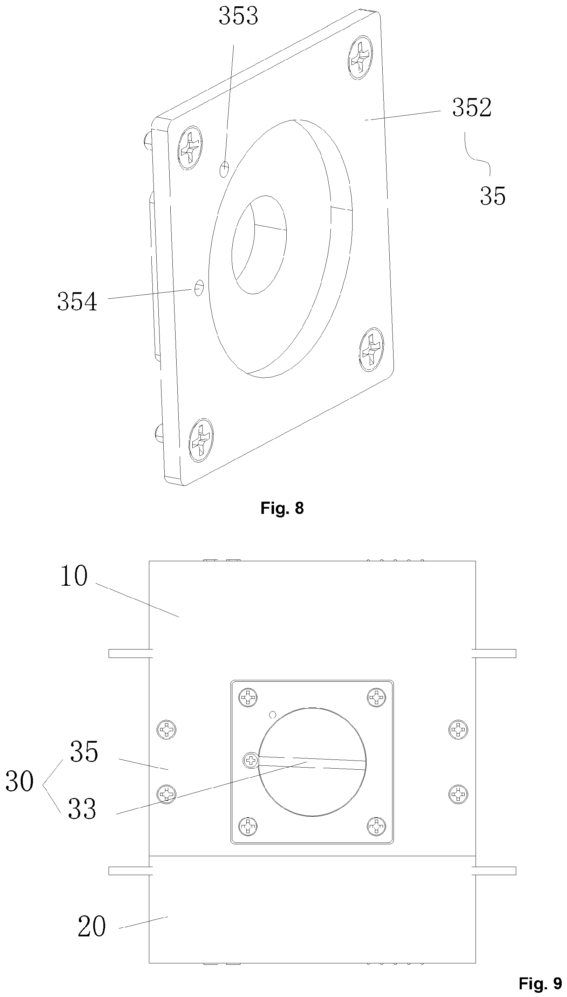

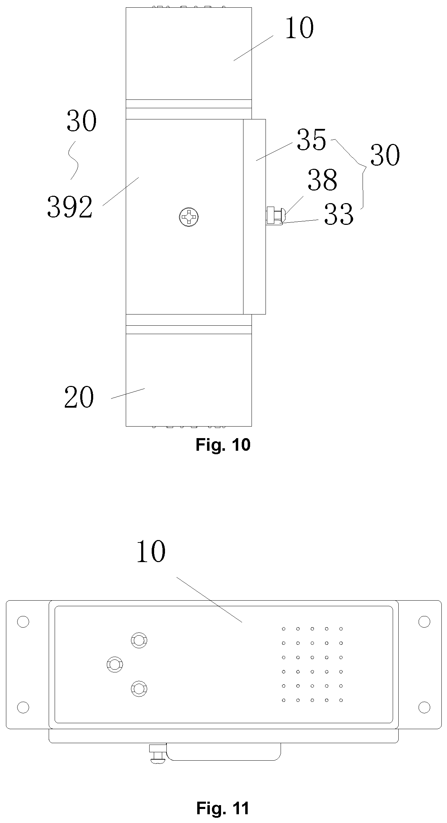

As shown in Figs. 6-12, the intermediate structure 30 further includes a locking member 38 movably arranged on the driving member 33. A first locking portion 353 and a second locking portion 354 that are spaced apart from each other are arranged on the separator 35. When the driving member 33 is in the pushing position, the locking member 38 matches the first locking portion 353 in a locking manner. In this way, the third plug-in connection member 31 is maintained at a position for being connected with the first plug-in connection member 10 in a plug-in manner, and the fourth plug-in connection member 32 in maintained in a position for being connected with the second plug-in connection member 20 in a plug-in manner and is less likely to get loose. Moreover, it is guaranteed that the third plug-in connection member 31 may be reliably connected with the first plug-in connection member 10 in a plug-in manner, and the fourth plug-in connection member 32 may be reliably connected with the second plug-in connection member 20 in a plug-in manner, such that a desirable contact effect is maintained, and poor contact is avoided. When the driving member 33 is in the initial position, the locking member 38 may match the second locking portion 354 in a locking manner. In this way, the third plug-in connection member 31 is maintained at a position for being separated from the first plug-in connection member 10, and the fourth plug-in connection member 32 is maintained at a position for being separated from the second plug-in connection member 20, such that loosening is not likely to occur, and danger caused by misoperation is avoided.

Specifically, for screwing and ease of operation, the locking member 38 includes a bolt, the first locking portion 353 includes a first screw hole, and the second locking portion 354 includes a second screw hole.

As shown in Figs. 2-13, the intermediate structure 30 further includes a fixing plate 391 and two limiting folded plates 392 arranged at two ends of the fixing plate 391, a part of the separator 35 is fixed at a middle position of the fixing plate 391, and the third plug-in connection member 31 and the fourth plug-in connection member 32 are located between the two limiting folded plates 392. The fixing plate 391 and the two limiting folded plates 392 limit the third plug-in connection member 31 and the fourth plug-in connection member 32 to guide linear movement of the third plug-in connection member 31 and the fourth plug-in connection member 32, such that the third plug-in connection member 31 is aligned with the first plug-in connection member 10, and the fourth plug-in connection member 32 is aligned with the second plug-in connection member 20. Therefore, the third plug-in connection member 31 may be quickly connected with the first plug-in connection member 10 in a plug-in manner, and the fourth plug-in connection member 32 may be quickly connected with the second plug-in connection member 20 in a plug-in manner. The fixing plate 391 and the two limiting folded plates 392 arranged on the two ends of the fixing plate 391 are plastic parts of an integral structure.

As shown in Figs. 2-13, when the driving member 33 is in the initial position, the third plug-in connection member 31 and the fourth plug-in connection member 32 are close to each other, the third plug-in connection member 31 is separated from the first plug-in connection member 10, and the fourth plug-in connection member 32 is separated from the second plug-in connection member 20. In this way, the intermediate structure 30 is movably located between the first plug-in connection member 10 and the second plug-in connection member 20. In order to enable the third plug-in connection member 31 to be smoothly connected with the first plug-in connection member 10 in a plug-in manner, and enable the fourth plug-in connection member 32 to be smoothly connected with the second plug-in connection member 20 in a plug-in manner, a first positioning structure is arranged between the third plug-in connection member 31 and the first plug-in connection member 10, and a second positioning structure is arranged between the fourth plug-in connection member 32 and the second plug-in connection member 20.

Specifically, in order to conveniently guide and position plug-in connection between the third plug-in connection member 31 and the first plug-in connection member 10, the first positioning structure includes a first positioning column and a first positioning hole matching the first positioning column in a positioning manner, the first positioning hole is provided on the first plug-in connection member 10, and the first positioning column is arranged on the third plug-in connection member 31. In order to conveniently guide and position plug-in connection between the fourth plug-in connection member 32 and the second plug-in connection member 20, the second positioning structure includes a second positioning column and a second positioning hole matching the second positioning column in a positioning manner, the second positioning hole is provided on the second plug-in connection member 20, and the second positioning column is arranged on the fourth plug-in connection member 32.

In the embodiment, the rotary shaft 331 is driven to rotate by rotating a knob such that the driving block 332 may simultaneously push the third plug-in connection member 31 to move upwards and push the fourth plug-in connection member 32 to move downwards. The third plug-in connection member 31 may be connected with the first plug-in connection member 10 in a plug-in manner, and the fourth plug-in connection member 32 may be connected with the second plug-in connection member 20 in a plug-in manner. In this way, the driving member 33 is in the pushing position, such that the first plug-in connection member 10, the third plug-in connection member 31, the fourth plug-in connection member 32 and the second plug-in connection member 20 may be in communication with each other. On the contrary, when the driving member 33 is switched from the pushing position to the initial position, under the pulling force of the elastic member, the third plug-in connection member 31 may be separated from the first plug-in connection member 10, and the fourth plug-in connection member 32 may be separated from the second plug-in connection member 20. In this way, the intermediate structure 30 may be moved out.

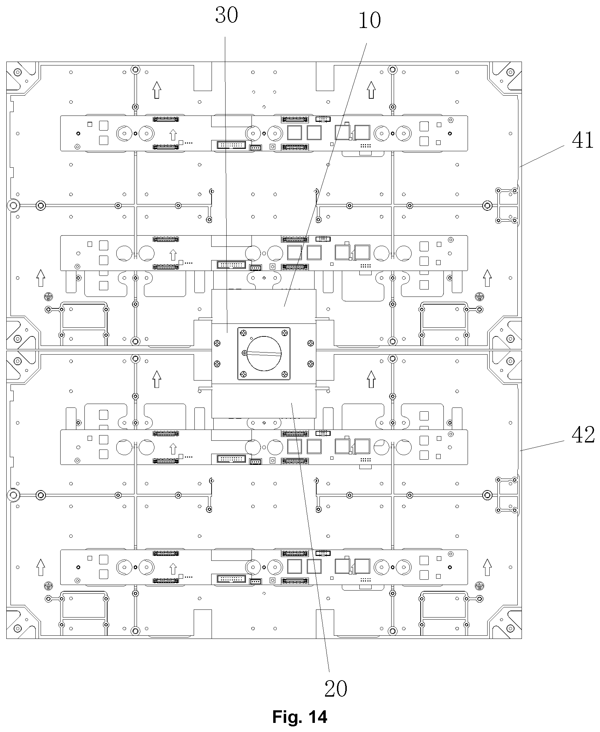

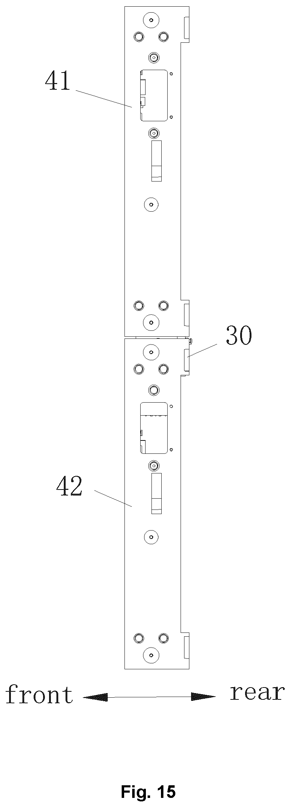

The invention further provides an LED box assembly. As shown in Figs. 14 and 15, the LED box assembly in the embodiment includes a first box 41, a second box 42 and a plug-in connection assembly, and the plug-in connection assembly is the above plug-in connection assembly of an LED display device. Since the above plug-in connection assembly of an LED display device may solve the problem of insecurity caused because wires are distributed at backs of LED boxes, the LED box assembly including the plug-in connection assembly may solve the same technical problem. The first box 41 and the second box 42 are arranged adjacent to each other, the first box 41 includes a first side plate, the second box 42 includes a second side plate adjacent to the first side plate, the first plug-in connection member 10 of the plug-in connection assembly is arranged at the first side plate, and the second plug-in connection member 20 of the plug-in connection assembly is arranged at the second side plate. Specifically, the first side plate is provided with a first avoiding hole for avoiding one part of the intermediate structure 30, and the second side plate is provided with a second avoiding hole for avoiding the other part of the intermediate structure 30.

The invention further provides an LED display device. The LED display device includes an LED box assembly and an LED display screen arranged on a front side of the LED box assembly, and the LED box assembly is the above LED box assembly. Since the above LED box assembly may solve the problem of insecurity caused because wires are distributed at backs of LED boxes, the LED display device including the LED box assembly may solve the same technical problem.

## Claims

1. A power and data plug-in connection assembly for a light-emitting diode (LED) display device, comprising:
a first plug-in connection member (10) suitable to be arranged at a first side plate of a first box of a LED box assembly of the LED display device;
a second plug-in connection member (20) spaced apart from the first plug-in connection member (10) and suitable to be arranged at a second side plate of a second box of the LED box assembly of the LED display device;
**characterized in that**, the power and data plug-in connection assembly further comprises:
an intermediate structure (30) arranged between the first plug-in connection member (10) and the second plug-in connection member (20), wherein the intermediate structure (30) comprises a third plug-in connection member (31) and a fourth plug-in connection member (32) that are spaced apart from each other, and a driving member (33) for driving the third plug-in connection member (31) and the fourth plug-in connection member (32) to move, and the third plug-in connection member (31) and the fourth plug-in connection member (32) are connected with each other by a wire (34); wherein
the driving member (33) has an initial position and a pushing position; when the driving member (33) is in the initial position, the third plug-in connection member (31) and the fourth plug-in connection member (32) are close to each other, the third plug-in connection member (31) is separated from the first plug-in connection member (10), and the fourth plug-in connection member (32) is separated from the second plug-in connection member (20); and when the driving member (33) is in the pushing position, the third plug-in connection member (31) and the fourth plug-in connection member (32) are away from each other, the third plug-in connection member (31) is connected with the first plug-in connection member (10) in a plug-in manner, and the fourth plug-in connection member (32) is connected with the second plug-in connection member (20) in a plug-in manner.

2. The plug-in connection assembly as claimed in claim 1, wherein the intermediate structure (30) further comprises a separator (35) for separating the third plug-in connection member (31) from the fourth plug-in connection member (32), and the driving member (33) is rotatably arranged at the separator (35).

3. The plug-in connection assembly as claimed in claim 2, wherein the separator (35) comprises a separation frame (351) arranged between the third plug-in connection member (31) and the fourth plug-in connection member (32) and a connection plate (352) arranged at the separation frame (351), and the driving member (33) is rotatably arranged at the connection plate (352).

4. The plug-in connection assembly as claimed in claim 3, wherein the driving member (33) comprises a rotary shaft (331), a driving block (332) arranged at a first end of the rotary shaft (331), and an operation portion (333) arranged at a second end of the rotary shaft (331), an axis of the rotary shaft (331) is perpendicular to a moving direction of the third plug-in connection member (31) or the fourth plug-in connection member (32), the rotary shaft (331) rotatably penetrates the connection plate (352), and the driving block (332) can push the third plug-in connection member (31) and the fourth plug-in connection member (32), so as to drive the third plug-in connection member (31) and the fourth plug-in connection member (32) to be away from each other.

5. The plug-in connection assembly as claimed in claim 4, wherein the intermediate structure (30) further comprises a rotary sleeve (36) sleeving the rotary shaft (331) and fixed to the rotary shaft (331), the rotary sleeve (36) comprises a sleeve body (361) located between the connection plate (352) and the rotary shaft (331), and a stop plate (362) arranged at an end of the sleeve body (361) away from the operation portion (333), and the stop plate (362) and the operation portion (333) are located on two sides of the connection plate (352) respectively.

6. The plug-in connection assembly as claimed in claim 1, wherein the intermediate structure (30) further comprises an elastic member (37) connected between the third plug-in connection member (31) and the fourth plug-in connection member (32), and the elastic member (37) exerts an elastic force on the third plug-in connection member (31) and the fourth plug-in connection member (32), so as to move the third plug-in connection member (31) and the fourth plug-in connection member (32) from positions away from each other to positions close to each other.

7. The plug-in connection assembly as claimed in claim 2, wherein the intermediate structure (30) further comprises a locking member (38) movably arranged on the driving member (33), a first locking portion (353) and a second locking portion (354) that are spaced apart from each other are arranged on the separator (35), when the driving member (33) is in the pushing position, the locking member (38) can match the first locking portion (353) in a locking manner, and when the driving member (33) is in the initial position, the locking member (38) can match the second locking portion (354) in a locking manner.

8. The plug-in connection assembly as claimed in claim 2, wherein the intermediate structure (30) further comprises a fixing plate (391) and two limiting folded plates (392) arranged at two ends of the fixing plate (391), a part of the separator (35) is fixed at a middle position of the fixing plate (391), and the third plug-in connection member (31) and the fourth plug-in connection member (32) are located between the two limiting folded plates (392).

9. The plug-in connection assembly as claimed in claim 1, wherein a first positioning structure is arranged between the third plug-in connection member (31) and the first plug-in connection member (10), and a second positioning structure is arranged between the fourth plug-in connection member (32) and the second plug-in connection member (20).

10. An LED box assembly, comprising a first box (41), a second box (42) and a plug-in connection assembly, wherein the plug-in connection assembly is the plug-in connection assembly of an LED display device of any one of claims 1-9, the first box (41) and the second box (42) are arranged adjacent to each other, the first box (41) comprises a first side plate, the second box (42) comprises a second side plate adjacent to the first side plate, a first plug-in connection member (10) of the plug-in connection assembly is arranged at the first side plate, and a second plug-in connection member (20) of the plug-in connection assembly is arranged at the second side plate.

11. An LED display device, comprising an LED box assembly and an LED display screen arranged on a front side of the LED box assembly, wherein the LED box assembly is the LED box assembly of claim 10.

## Patentansprüche

1. Strom- und Daten-Steckverbindungsanordnung für eine Leuchtdioden-(LED)-Anzeigevorrichtung, umfassend:
ein erstes Steckverbindungselement (10), das zur Anordnung an einer ersten Seitenplatte eines ersten Kastens einer LED-Kastenanordnung der LED-Anzeigevorrichtung geeignet ist;
ein zweites Steckverbindungselement (20), das vom ersten Steckverbindungselement (10) beabstandet ist und zur Anordnung an einer zweiten Seitenplatte eines zweiten Kastens der LED-Kastenanordnung der LED-Anzeigevorrichtung geeignet ist;
**dadurch gekennzeichnet, dass** die Strom- und Datensteckverbindungsanordnung weiterhin Folgendes umfasst:
eine zwischen dem ersten Steckverbindungselement (10) und dem zweiten Steckverbindungselement (20) angeordnete Zwischenstruktur (30), wobei die Zwischenstruktur (30) ein drittes Steckverbindungselement (31) und ein viertes Steckverbindungselement (32), die voneinander beabstandet sind, sowie ein Antriebselement (33) umfasst, um das dritte Steckverbindungselement (31) und das vierte Steckverbindungselement (32) zu bewegen, und das dritte Steckverbindungselement (31) und das vierte Steckverbindungselement (32) durch einen Draht (34) miteinander verbunden sind; wobei
das Antriebselement (33) eine Ausgangsposition und eine Schubposition aufweist; wenn sich das Antriebselement (33) in der Ausgangsposition befindet, das dritte Steckverbindungselement (31) und das vierte Steckverbindungselement (32) nahe beieinander liegen, das dritte Steckverbindungselement (31) vom ersten Steckverbindungselement (10) getrennt ist und das vierte Steckverbindungselement (32) vom zweiten Steckverbindungselement (20) getrennt ist; und wenn sich das Antriebselement (33) in der Schubposition befindet, das dritte Steckverbindungselement (31) und das vierte Steckverbindungselement (32) voneinander entfernt sind, das dritte Steckverbindungselement (31) mit dem ersten Steckverbindungselement (10) steckverbunden ist und das vierte Steckverbindungselement (32) mit dem zweiten Steckverbindungselement (20) steckverbunden ist.

2. Steckverbindungsanordnung nach Anspruch 1, wobei die Zwischenstruktur (30) ferner ein Trennelement (35) zum Trennen des dritten Steckverbindungselements (31) vom vierten Steckverbindungselement (32) umfasst und das Antriebselement (33) drehbar am Trennelement (35) angeordnet ist.

3. Steckverbindungsanordnung nach Anspruch 2, wobei der Trennelement (35) einen zwischen dem dritten Steckverbindungselement (31) und dem vierten Steckverbindungselement (32) angeordneten Trennrahmen (351) und eine am Trennrahmen (351) angeordnete Verbindungsplatte (352) umfasst, und das Antriebselement (33) drehbar an der Verbindungsplatte (352) angeordnet ist.

4. Steckverbindungsanordnung nach Anspruch 3, wobei das Antriebselement (33) eine Drehwelle (331), einen Antriebsblock (332), der an einem ersten Ende der Drehwelle (331) angeordnet ist, und einen Betätigungsabschnitt (333), der an einem zweiten Ende der Drehwelle (331) angeordnet ist, umfasst, eine Achse der Drehwelle (331) senkrecht zu einer Bewegungsrichtung des dritten Steckverbindungselements (31) oder des vierten Steckverbindungselements (32) steht, die Drehwelle (331) die Anschlussplatte (352) drehbar durchdringt, und der Antriebsblock (332) das dritte Steckverbindungselement (31) und das vierte Steckverbindungselement (32) drücken kann, um das dritte Steckverbindungselement (31) und das vierte Steckverbindungselement (32) voneinander weg zu treiben.

5. Steckverbindungsanordnung nach Anspruch 4, wobei die Zwischenstruktur (30) ferner eine Drehhülse (36) umfasst, die die Drehwelle (331) umschließt und an der Drehwelle (331) befestigt ist, die Drehhülse (36) einen Hülsenkörper (361), der sich zwischen der Verbindungsplatte (352) und der Drehwelle (331) befindet, und eine Anschlagplatte (362) umfasst, die an einem Ende des Hülsenkörpers (361) entfernt vom Betätigungsabschnitt (333) angeordnet ist, und sich die Anschlagplatte (362) und der Betätigungsabschnitt (333) jeweils auf zwei Seiten der Verbindungsplatte (352) befinden.

6. Steckverbindungsanordnung nach Anspruch 1, wobei die Zwischenstruktur (30) ferner ein elastisches Element (37) umfasst, das zwischen dem dritten Steckverbindungselement (31) und dem vierten Steckverbindungselement (32) angeschlossen ist, und das elastische Element (37) eine elastische Kraft auf das dritte Steckverbindungselement (31) und das vierte Steckverbindungselement (32) ausübt, um das dritte Steckverbindungselement (31) und das vierte Steckverbindungselement (32) aus voneinander entfernten Positionen in einander nahe Positionen zu bewegen.

7. Steckverbindungsanordnung nach Anspruch 2, wobei die Zwischenstruktur (30) ferner ein Verriegelungselement (38) umfasst, das beweglich am Antriebselement (33) angeordnet ist, ein erster Verriegelungsabschnitt (353) und ein zweiter Verriegelungsabschnitt (354), die voneinander beabstandet sind, an dem Trennelement (35) angeordnet sind, wenn sich das Antriebselement (33) in der Schubposition befindet, das Verriegelungselement (38) mit dem ersten Verriegelungsabschnitt (353) verriegelnd zusammenpassen kann, und wenn sich das Antriebselement (33) in der Ausgangsposition befindet, das Verriegelungselement (38) mit dem zweiten Verriegelungsabschnitt (354) verriegelnd zusammenpassen kann.

8. Steckverbindungsanordnung nach Anspruch 2, wobei die Zwischenstruktur (30) ferner eine Befestigungsplatte (391) und zwei begrenzende Faltplatten (392) umfasst, die an zwei Enden der Befestigungsplatte (391) angeordnet sind, ein Teil des Separators (35) an einer mittleren Position der Befestigungsplatte (391) befestigt ist und das dritte Steckverbindungselement (31) und das vierte Steckverbindungselement (32) zwischen den beiden begrenzenden Faltplatten (392) angeordnet sind.

9. Steckverbindungsanordnung nach einem der vorhergehenden Ansprüche, **dadurch gekennzeichnet, dass** zwischen dem dritten Steckverbindungselement (31) und dem ersten Steckverbindungselement (10) eine erste Positionierstruktur und zwischen dem vierten Steckverbindungselement (32) und dem zweiten Steckverbindungselement (20) eine zweite Positionierstruktur angeordnet ist.

10. LED-Box-Anordnung, umfassend eine erste Box (41), eine zweite Box (42) und eine Steckverbindungsanordnung, wobei die Steckverbindungsanordnung die Steckverbindungsanordnung einer LED-Anzeigevorrichtung nach einem der Ansprüche 1 bis 9 ist, die erste Box (41) und die zweite Box (42) nebeneinander angeordnet sind, die erste Box (41) eine erste Seitenplatte umfasst, die zweite Box (42) eine zweite Seitenplatte aufweist, die an die erste Seitenplatte angrenzt, ein erstes Steckverbindungselement (10) der Steckverbindungsanordnung an der ersten Seitenplatte und ein zweites Steckverbindungselement (20) der Steckverbindungsanordnung an der zweiten Seitenplatte angeordnet ist.

11. LED-Anzeigevorrichtung, umfassend eine LED-Box-Anordnung und einen auf einer Vorderseite der LED-Box-Anordnung angeordneten LED-Anzeigebildschirm, wobei die LED-Box-Anordnung die LED-Box-Anordnung nach Anspruch 10 ist.

## Revendications

1. Ensemble de connexion enfichable d'alimentation et de données pour un dispositif d'affichage à diodes électroluminescentes (LED), comprenant :
un premier élément de connexion enfichable (10) adapté pour être disposé sur une première plaque latérale d'un premier boîtier d'un ensemble de boîtier à LED du dispositif d'affichage LED ;
un deuxième élément de connexion enfichable (20) espacé du premier élément de connexion enfichable (10) et adapté pour être disposé sur une seconde plaque latérale d'un second boîtier de l'ensemble de boîtier à LED du dispositif d'affichage LED ;
**caractérisé en ce que**, l'ensemble de connexion enfichable d'alimentation et de données comprend en outre :
une structure intermédiaire (30) disposée entre le premier élément de connexion enfichable (10) et le deuxième élément de connexion enfichable (20), dans lequel la structure intermédiaire (30) comprend un troisième élément de connexion enfichable (31) et un quatrième élément de connexion enfichable (32) espacés l'un de l'autre, et un élément d'entraînement (33) pour entraîner le troisième élément de connexion enfichable (31) et le quatrième élément de connexion enfichable (32) à se déplacer, et le troisième élément de connexion enfichable (31) et le quatrième élément de connexion enfichable (32) sont reliés l'un à l'autre par un fil (34) ; dans lequel
l'élément d'entraînement (33) présente une position initiale et une position de poussée ; lorsque l'élément d'entraînement (33) est en position initiale, le troisième élément de connexion enfichable (31) et le quatrième élément de connexion enfichable (32) sont proches l'un de l'autre, le troisième élément de connexion enfichable (31) est séparé du premier élément de connexion enfichable (10), et le quatrième élément de connexion enfichable (32) est séparé du deuxième élément de connexion enfichable (20) ; et lorsque l'élément d'entraînement (33) est en position de poussée, le troisième élément de connexion enfichable (31) et le quatrième élément de connexion enfichable (32) sont éloignés l'un de l'autre, le troisième élément de connexion enfichable (31) est connecté au premier élément de connexion enfichable (10) par enfichage, et le quatrième élément de connexion enfichable (32) est connecté au deuxième élément de connexion enfichable (20) par enfichage.

2. Ensemble de connexion enfichable selon la revendication 1, dans lequel la structure intermédiaire (30) comprend en outre un séparateur (35) pour séparer le troisième élément de connexion enfichable (31) du quatrième élément de connexion enfichable (32), et l'élément d'entraînement (33) est disposé de manière rotative au niveau du séparateur (35).

3. Ensemble de connexion enfichable selon la revendication 2, dans lequel le séparateur (35) comprend un cadre de séparation (351) disposé entre le troisième élément de connexion enfichable (31) et le quatrième élément de connexion enfichable (32) et une plaque de connexion (352) disposée au niveau du cadre de séparation (351), et l'élément d'entraînement (33) est disposé de manière rotative au niveau de la plaque de connexion (352).

4. Ensemble de connexion enfichable selon la revendication 3, dans lequel l'élément d'entraînement (33) comprend un arbre rotatif (331), un bloc d'entraînement (332) disposé à une première extrémité de l'arbre rotatif (331), et une partie d'actionnement (333) disposée à une seconde extrémité de l'arbre rotatif (331), un axe de l'arbre rotatif (331) est perpendiculaire à une direction de déplacement du troisième élément de connexion enfichable (31) ou du quatrième élément de connexion enfichable (32), l'arbre rotatif (331) pénètre de manière rotative dans la plaque de connexion (352), et le bloc d'entraînement (332) peut pousser le troisième élément de connexion enfichable (31) et le quatrième élément de connexion enfichable (32), de manière à entraîner le troisième élément de connexion enfichable (31) et le quatrième élément de connexion enfichable (32) à s'éloigner l'un de l'autre.

5. Ensemble de connexion enfichable selon la revendication 4, dans lequel la structure intermédiaire (30) comprend en outre un manchon rotatif (36) enveloppant l'arbre rotatif (331) et fixé à l'arbre rotatif (331), le manchon rotatif (36) comprend un corps de manchon (361) situé entre la plaque de connexion (352) et l'arbre rotatif (331), et une plaque d'arrêt (362) disposée à une extrémité du corps de manchon (361) éloignée de la partie d'actionnement (333), et la plaque d'arrêt (362) et la partie d'actionnement (333) sont situées sur deux côtés de la plaque de connexion (352) respectivement.

6. Ensemble de connexion enfichable selon la revendication 1, dans lequel la structure intermédiaire (30) comprend en outre un élément élastique (37) connecté entre le troisième élément de connexion enfichable (31) et le quatrième élément de connexion enfichable (32), et l'élément élastique (37) exerce une force élastique sur le troisième élément de connexion enfichable (31) et le quatrième élément de connexion enfichable (32), de manière à déplacer le troisième élément de connexion enfichable (31) et le quatrième élément de connexion enfichable (32) de positions éloignées l'une de l'autre à des positions proches l'une de l'autre.

7. Ensemble de connexion enfichable selon la revendication 2, dans lequel la structure intermédiaire (30) comprend en outre un élément de verrouillage (38) disposé de manière mobile sur l'élément d'entraînement (33), une première partie de verrouillage (353) et une seconde partie de verrouillage (354) qui sont espacées l'une de l'autre sont disposées sur le séparateur (35), lorsque l'élément d'entraînement (33) est dans la position de poussée, l'élément de verrouillage (38) peut correspondre à la première partie de verrouillage (353) d'une manière de verrouillage, et lorsque l'élément d'entraînement (33) est dans la position initiale, l'élément de verrouillage (38) peut correspondre à la seconde partie de verrouillage (354) d'une manière de verrouillage.

8. Ensemble de connexion enfichable selon la revendication 2, dans lequel la structure intermédiaire (30) comprend en outre une plaque de fixation (391) et deux plaques pliées de limitation (392) disposées aux deux extrémités de la plaque de fixation (391), une partie du séparateur (35) est fixée à une position médiane de la plaque de fixation (391), et le troisième élément de connexion enfichable (31) et le quatrième élément de connexion enfichable (32) sont situés entre les deux plaques pliées de limitation (392).

9. Ensemble de connexion enfichable selon la revendication 1, dans lequel une première structure de positionnement est disposée entre le troisième élément de connexion enfichable (31) et le premier élément de connexion enfichable (10), et une seconde structure de positionnement est disposée entre le quatrième élément de connexion enfichable (32) et le deuxième élément de connexion enfichable (20).

10. Ensemble de boîtier à LED, comprenant un premier boîtier (41), un second boîtier (42) et un ensemble de connexion enfichable, dans lequel l'ensemble de connexion enfichable est l'ensemble de connexion enfichable d'un dispositif d'affichage à LED selon l'une quelconque des revendications 1 à 9, le premier boîtier (41) et le second boîtier (42) sont disposés adjacents l'un à l'autre, le premier boîtier (41) comprend une première plaque latérale, le second boîtier (42) comprend une seconde plaque latérale adjacente à la première plaque latérale, un premier élément de connexion enfichable (10) de l'ensemble de connexion enfichable est disposé au niveau de la première plaque latérale, et un deuxième élément de connexion enfichable (20) de l'ensemble de connexion enfichable est disposé au niveau de la seconde plaque latérale.

11. Dispositif d'affichage à LED, comprenant un ensemble de boîtier à LED et un écran d'affichage à LED disposé sur une face avant de l'ensemble de boîtier à LED, l'ensemble de boîtier à LED étant l'ensemble de boîtier à LED selon la revendication 10.
